Europäisches Patentamt

European Patent Office

Office européen des brevets

(19)

(11) Publication number: 0 355 691
A2

(12) **EUROPEAN PATENT APPLICATION**

(21) Application number: 89115101.1

(22) Date of filing: 16.08.89

(51) Int. Cl.4: H01L 29/784 , H01L 21/336

(30) Priority: 23.08.88 JP 209035/88
25.05.89 JP 130069/89

(43) Date of publication of application:
28.02.90 Bulletin 90/09

(84) Designated Contracting States:
DE FR GB NL

(71) Applicant: SEIKO EPSON CORPORATION
4-1, Nishishinjuku 2-chome
Shinjuku-ku Tokyo-to(JP)

(72) Inventor: Nakazaki, Yasunori c/o Seiko Epson
Corporation
3-5, Owa 3-chome
Suwa-shi Nagano-ken(JP)
Inventor: Kondo, Toshihiko c/o Seiko Epson
Corporation
3-5, Owa 3-chome
Suwa-shi Nagano-ken(JP)

(74) Representative: Blumbach Weser Bergen
Kramer Zwirner Hoffmann Patentanwälte
Radeckestrasse 43
D-8000 München 60(DE)

(54) Semiconductor device and process for producing the same.

(57) In an LDD transistor structure of MOS, a gate
electrode (106a) is positioned on a low-concentration
impurity drain (105) using a technique for forming a
side-wall (108) of a conductor material.

FIG. 1

# SEMICONDUCTOR DEVICE AND PROCESS FOR PRODUCING THE SAME

The present invention relates to a semiconductor device and a process for producing the same. More particularly, the present invention pertains to a MOS type semiconductor device having an LDD (Lightly Doped Drain) structure and a process for producing the same.

As a result of the achievement of high integration of semiconductor devices, for example, shrink or scale down of MOS (MIS) type transistors, the following problems have recently been experienced. First of all, as the channel length is shortened, a punch-through phenomenon occurs due to the short channel effect. Further, concentration of the high electric field occurs at the surface portion of the drain region which is closer to the channel surface, and hot electrons generated thereby are concentrated and accumulated in the insulating film edge of the edge of the gate electrode, resulting in a change in the characteristics of the transistor. This leads to a lowering in the conductance in the case of an n-channel transistor and causes a punch-through phenomenon in the case of a p-channel transistor. In order to solve the above-described problems, an LDD structure wherein the drain region is constituted by two regions having different concentrations has been widely adopted.

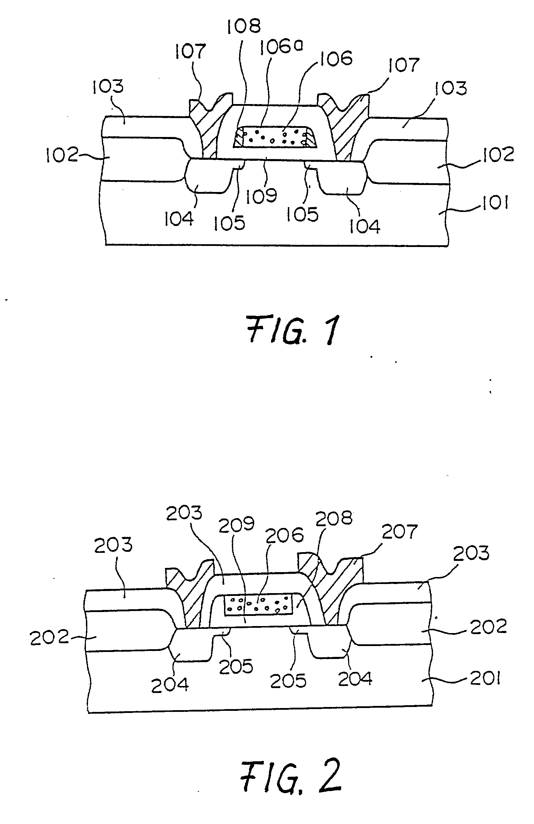

Fig. 2 is a fragmentary sectional view schematically showing the structure of a conventional MOS transistor having an LDD structure. In the figure, the reference numeral 201 denotes a semiconductor substrate, 202 an element isolation insulating film formed by LOCOS technique, 203 an interlayer insulating film, 204 high-concentration impurity regions formed in the semiconductor substrate 201 to constitute source/drain regions, respectively and 205 low-concentration impurity regions. The reference numeral 206 denotes a gate electrode, 207 interconnection electrodes led out from the source/drain regions, 208 a side-wall constituted by an insulating film, and 209 a gate insulating film.

To form the above-described MOS transistor, first, a diffused layer for the low-concentration impurity regions 205 is formed with the gate electrode 206 used as a mask. After an insulating film of SiO$_2$, PSG or the like has been deposited by a CVD method, the whole surface is subjected to dry etching to form the side-wall 208 on the side surface of the gate electrode 206. Thereafter, a diffused layer for the high-concentration impurity regions 204 is formed with the gate electrode 206 and the side-wall 208 used as masks. Thus, the impurity concentration in the drain edge directly below the gate is lowered, thereby reducing the concentration of the electric field, and thus enabling prevention of degradation due to hot carriers.

As a recent example of improvements in the LDD structure, the results of studies wherein an inverse T-shaped gate electrode is employed so that the gate electrode is extended to cover the channel region as far as the low-concentration impurity regions to thereby solve the above-described problems are disclosed, for example, in the following literature.

Literature: IEEE, IEDM 86, [31.7], (1986), (U.S.A.), p.742-745; Tiao-Yuan Huang et al., "A Novel Submicron LDD Transistor with Inverse-T gate structure".

It has become possible to prevent degradation due to hot carriers even with a conventional semiconductor device having an LDD structure and a process for producing the same, for example, the above-described prior art shown in Fig. 2. However, with a further reduction in the size of transistors, the following critical phenomenon has become prominent, that is, the low-concentration impurity region is pinched off by electric charges injected into the side-wall, which results in a lowering of the current driving capacity.

From the viewpoint of solving such a problem, the device structure and the process for producing the same, which are disclosed in the above-mentioned literature, are noticed as being considerably effective. However, in the process for forming the gate electrode, etching of the polycrystalline silicon layer that is carried out to form the gate electrode must be suspended halfway to form an inverse-T electrode and it is technically difficult to control the process such that the etching is suspended halfway. Therefore, it may be pointed out that the prior art still has the problem that it is difficult not only to realize a gate electrode structure such as that disclosed in the literature but also to provide a gate electrode forming process which has excellent reproducibility.

The present invention aims at solving the above-described problems while maintaining the device degradation preventing effectiveness of the LDD structure. More particularly, it is an object of the present invention to provide a gate electrode structure which can readily be realized and a process for producing the same which has excellent reproducibility.

This object is achieved with a MOS type semiconductor device as claimed in claim 1 and a process for producing it as claimed in claim 8.

Specific embodiments of the invention are claimed in the dependent claims.

According to the present invention, the gate electrode of a MOS type semiconductor device having an LDD structure is constituted by a first film and a second film, both of which are formed of conductive films in different steps, the first film having an ordinary configuration, the second film being formed on the side surface of the first film, and the resulting composite gate electrode is disposed over the channel region including the low-concentration impurity region of the LDD structure.

Further, the first and second films may be formed from conductor layers which are different from each other, and it is preferable that the etching rate of the first film be lower than that of the second film. The second film may be made of polycrystalline silicon, while the first film may be made of one selected from the group consisting of polycrystalline silicon, a refractory metal selected from among Mo, W and Ti, a silicide of the refractory metal, and a polycide of polycrystalline silicon and a silicide of refractory metal.

The process for producing a semiconductor device according to the present invention comprises the steps of forming a gate insulating film in an element forming region defined on a semiconductor substrate, forming a gate electrode in a predetermined position on the gate insulating film, forming a low-concentration impurity region on the semiconductor substrate at the outer side of the gate electrode, the low-concentration impurity region being of a conductivity type opposite to that of the semiconductor substrate, forming a conductor layer on the whole surface, subjecting the whole surface to anisotropic etching to form a side-wall conductor layer with the conventional side-wall configuration which is in contact with the outer side of the gate electrode, thereby forming a composite gate electrode, and forming a high-concentration impurity region outside of the side-wall conductor layer and the gate conductor made by the first layer with the composite gate electrode used as a mask, the high-concentration impurity region being of the same conductivity type as that of the low-concentration impurity region, thereby forming an LDD structure.

In the present invention, a composite gate electrode wherein a conductive side-wall is provided on the side surface of an ordinary gate electrode is formed in self alignment through two discrete steps, the gate electrode being disposed over the channel region of the device that includes the low-concentration impurity region constituting an LDD structure. Accordingly, it is possible to reduce the trap (accumulation) of electric charges due to hot carriers (including hot electrons) in the insulating film at the edge of the gate electrode. It is therefore possible to hold down the lowering of the conductance and the reduction in the current driving capacity due to the hot carrier phenomenon to such a level that no problem will arise. Thus, the transistor operates with substantially no change in the characteristics. Since the side-wall conductor of the gate electrode can be formed by utilizing the end point of the etching process, it is easy to control the etching process and also easy to reproduce the electrode configuration.

One way of carrying out the invention is described below with reference to drawings which illustrate a specific embodiment only, and in which:

Fig. 1 is a fragmentary sectional view of one embodiment of the semiconductor device according to the present invention;

Fig. 2 is a fragmentary sectional view of a conventional semiconductor device; and

Fig. 3(a) to 3(c) are fragmentary sectional views showing the steps of one embodiment of the process for producing a semiconductor device according to the present invention.

Fig. 1 is a fragmentary sectional view showing the structure of one embodiment of the semiconductor device of the present invention.

In the figure, the reference numeral 101 denotes a semiconductor substrate of, for example, silicon, and of, for example the P-type conductivity type, 102 an element isolation insulating film, and 104 high-concentration impurity regions formed in the semiconductor substrate 101 within an element forming region to constitute source/drain regions, respectively, the high-concentration impurity regions 104 being formed from a diffused layer of a conductivity type, for example, the N-type conductivity type, which is opposite to that of the semiconductor substrate 101. The reference numeral 105 denotes low-concentration impurity regions which are formed at the sides of the corresponding high-concentration impurity regions 104 which are closer to the channel, thereby constituting an LDD structure. The reference numeral 103 denotes an interlayer insulating film, and 107 interconnection electrodes of Al or the like which are led out onto the interlayer insulating film 103 from the source/drain regions through respective contact holes.

The reference numeral 106 denotes a gate electrode constituted by a first film, and 108 a side-wall conductor with an ordinary side-wall configuration which is constituted by a second film formed on the peripheral side-wall of the gate electrode 106. Thus, the gate electrode 106 and the side-wall conductor 108 constitute in combination a composite gate electrode 106a which is disposed over the channel region including the low-concentration impurity regions 105 through the gate insulating film 109. It should be noted that the side-wall conductor 108 is disposed so as to face the low-concentration impurity regions 105 across the gate insulating film 109. In this case, the first film (106) and the second film (108) are formed in different steps to constitute the composite gate electrode 106a. In general, the first film (106) and the second film (108) may be formed respectively from conductor layers which are different from each other. By using different conductor layers, the etching rate of the first film (106) can be set so as to be lower than that of the second film (108). Thus, it is possible to simplify the process for forming the gate electrode 106a.

With the above-described arrangement of the gate electrode 106a, if the side-wall conductor 108 is made of polycrystalline silicon, for example, the gate electrode 106 may be made of one selected from the group consisting of polycrystalline silicon, a refractory metal selected from among Mo, W and Ti, a silicide of the refractory metal, and a polycide of a silicide of the refractory metal and polycrystalline silicon.

Thus, the gate electrode 106a is formed so as to cover the low-concentration impurity regions 105 and it is therefore possible to attain a semiconductor device structure by which it is possible to prevent the short-channel effect by virtue of the LDD structure, and prevent the concentration of electric charges and eliminate hot electrons generated in the drain region at the side thereof which is closer to the channel even more effectively than the conventional LDD structure.

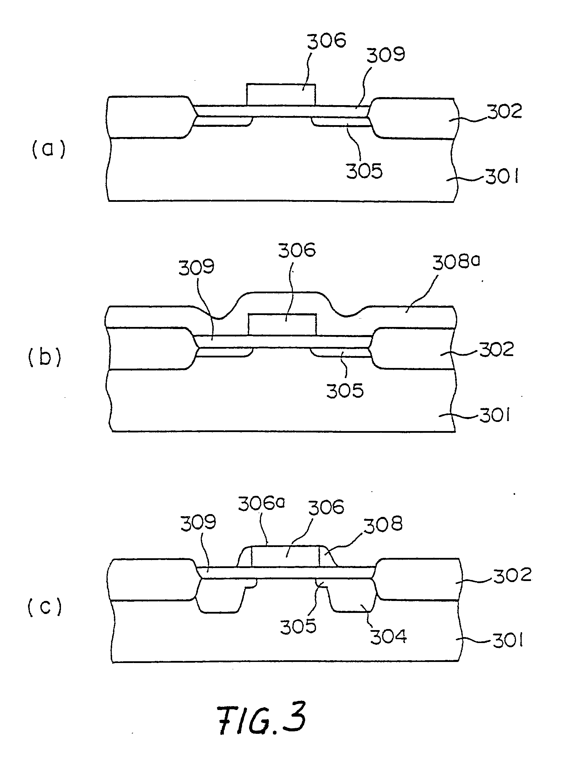

Figs. 3(a) to 3(c) are fragmentary sectional views showing the steps of one embodiment of the process for producing a semiconductor device according to the present invention. The following description will be made by way of an example in which both the first and second films are made of polycrystalline silicon. It should be noted that a supplementary example in which another material is employed to form the first film will also be explained below.

Referring to Fig. 3(a), an element isolation insulating film 302 with a thickness of 0.4 to 0.7μm (4000 to 7000Å) is formed on a semiconductor substrate 301 or a well region (not shown) by an ordinary process employing a LOCOS method carried out in a wet atmosphere at 900 to 1000°C. Thereafter, a gate insulating film 309 with a thickness of 0.015 to 0.04μm (150 to 400Å) is formed in a wet atmosphere at 900 to 1000°C. Then, a polycrystalline silicon film with a thickness of 0.4 to 0.5μm (4000 to 5000Å) is formed by thermal decomposition of $SiH_4$ carried out at 600 to 650°C. Thereafter, etching is carried out by ordinary photolithography in such a manner that the polycrystalline silicon film is left only in a predetermined gate forming region, thereby forming a gate electrode 306. With the gate electrode 306 used as a mask, ion implantation is carried out using impurity ions of a conductivity type opposite to that of the semiconductor substrate 301 to form a low-concentration impurity region 305. In the case of an N-channel transistor employing a P-type semiconductor substrate 301, the ion implantation is carried out using 31 $P^+$ under conditions of an implantation energy of 60 keV and a dose amount of 1 to 5 x $10^{13}$ cm$^{-2}$.

Referring next to Fig. 3(b), a polycrystalline film is deposited to a thickness of 0.4 to 0.5μm (4000 to 5000Å) on the whole surface in the same way as in the process described in connection with Fig. 3(a), thereby forming a polycrystalline silicon layer 308a.

Referring to Fig. 3(c), first, the polycrystalline silicon layer 308a is subjected to anisotropic etching by dry etching using, for example, a mixed gas of $SF_5$ and $C_2ClF_5$, thereby self-alignedly forming a side-wall conductor layer 308 in the shape of a side-wall on the side-wall of the gate electrode 306. At this time, if the gate electrode 306 and the side-wall conductor layer 308 are made of the same material as in this example, the etching end point of the polycrystalline silicon layer 308a can readily be judged and it is therefore possible to form a composite gate electrode 306a (corresponding to 106a in Fig. 1) in which the respective upper surfaces of the gate electrode 306 and the side-wall conductor layer 308 are completely flush with each other. In this case, it is preferable that the side-wall conductor layer 308 be made of polycrystalline silicon, which provides an excellent step coverage and which is easy to etch. Then, impurity ions of the same conductivity type as that of the impurity ions used to form the low-concentration impurity region 305 are implanted to form a high-concentration impurity region 304. In the case of an N-channel transistor, for example, $As^+$ is ion-implanted under conditions of 80 keV and 6 to 10 x $10^{15}$ cm$^{-2}$. Thus, the composite gate electrode 306a is formed on the gate insulating film 309 so as to cover the low-concentration impurity region 305.

Then, after an interlayer insulating film is deposited, contact holes are formed therein and interconnection electrodes are formed in the contact holes by patterning, although these steps are not illustrated, thus obtaining a semiconductor device having the structure shown in Fig. 1.

Although in the foregoing embodiment both the first and second films constituting the composite gate electrode 306a are made of polycrystalline silicon, in some cases employment of different materials for the first and second films is more advantageous from the viewpoint of the structure, function and production process. For example, if a refractory metal is employed to form the gate electrode 306, the interconnection resistance is lowered and patterning is bettered.

From the above-described point of view, in the formation of the gate electrode 306 in the step shown in Fig. 3(a), one selected from the group consisting of a refractory metal such as Mo, W or Ti, a silicide of the refractory metal, and a polycide of a silicide of the refractory metal and polycrystalline silicon may be employed in place of the polycrystalline silicon. In such a case, the above-described refractory metal is formed to a thickness of 0.4 to 0.5μm (4000 to 5000Å) by sputtering. In the case of a polycide, two layers of polycrystalline silicon and a refractory metal or polycrystalline silicon and a refractory metal silicide may be formed so that the total thickness of the two layers is 0.4 to 0.5μm (4000 to 5000Å).

As has been described above in connection with the step shown in Fig. 3(c), after forming the second film (308a of Fig. 3(b)), if the gate electrode 306 and the side-wall conductor layer 308 are made of the same material, the etching end point can be judged in the anisotropic etching carried out to form the side-wall conductor layer 308. In this case, however, there is a fear of the gate electrode 306 becoming excessively thin. To eliminate such a problem, it suffices to employ different materials for the gate electrode 306 and the side-wall conductor layer 308 (or 308a) so that the etching rate of the gate electrode 306 is lower than that of the side-wall conductor layer 308. As one example, if the gate electrode 306 is formed using a MoSi polycide with a two-layer structure in which MoSi is stacked over polycrystalline silicon, while the side-wall conductor layer 308 is made of polycrystalline silicon, and dry etching is carried out using the above-mentioned etching gas, then the ratio of the etching rate of the MoSi polycide to that of polycrystalline silicon can be set at 1:2 to 3. In such a case, it is preferable to employ polycrystalline silicon for the side-wall conductor layer 308 due to the above-described reasons. As will be clear from the foregoing, when different materials are employed to form the first and second films that constitute in combination a composite gate electrode, it is important to select materials while taking into consideration the combination of the etching rates of the materials from the viewpoint of the efficiency of the production process of the present invention.

As has been described above, according to the present invention, a side-wall conductor layer in the shape of a side-wall is provided on a conventional gate electrode to constitute an extended composite gate electrode which is disposed over the low-concentration impurity region constituting an LDD structure. Thus, in the resulting MOS type semiconductor device, the pinch-off phenomenon due to hot carriers is suppressed and it is therefore possible to prevent marked lowering in the current driving capacity. Accordingly, the device performance can be maintained even if the size of the device structure is further reduced and it is therefore possible to apply the present invention to semiconductor devices of higher integration that the present level.

## Claims

1. A MOS type semiconductor device comprising an impurity-diffused layer including a high-concentration impurity region (104) and a low-concentration impurity region (105) formed in connection with said high-concentration impurity region; and a gate electrode (106a) constituted of a first film (106) and a second film (108), which are formed in their respective steps, said second film being formed on the side surface of said first film, wherein said gate electrode is formed over a channel region including said low-concentration impurity region.

2. A semiconductor device according to claim 1, wherein said second film (108) constituting a part of said gate electrode (106a) is in opposing relation to said low-concentration impurity region (105).

3. A semiconductor device according to claim 1 or 2, wherein said first and second films (106, 108) are formed respectively from conductor layers which are different from each other.

4. A semiconductor device according to any of claims 1 to 3, wherein said first film (106) is formed from a conductor layer the etching rate of which is smaller than that of said second film (108).

5. A semiconductor device according to any of claims 1 to 4, wherein at least said second film (108) is made of polycrystalline silicon.

6. A semiconductor device according to any of claims 1 to 4, wherein said first film (106) includes polycrystal line silicon, a refractory metal such as Mo, W or Ti, a silicide of said refractory metal, or a polycide composed of said polycrystalline silicon and a silicide of said refractory metal.

7. A semiconductor device according to any of claims 1 to 6, wherein said impurity-diffused layer (104, 105) and said gate electrode (106a) are doped with an impurity of the same conductivity type.

8. A process for producing a MOS type semiconductor device having an LDD structure designed to reduce the electric field in the vicinity of the drain, comprising the step of;
forming an element isolation insulating film (302) on a semiconductor substrate (301) and then forming a gate insulating film (309);
forming a gate electrode (306) in a predetermined position on said gate insulating film;
forming a layer of a low-concentration impurity region (305) on said semiconductor substrate (301) outside said gate electrode (306), said low-concentration impurity region being of a conductivity type opposite to that of said semiconductor substrate;

forming a conductor layer (308a) on the whole surface; anisotropically etching the whole surface to form a side-wall conductor layer (308) made of said conductor layer and being in contact with the outer side of said gate electrode (306); and

forming a layer of a high-concentration impurity region (304) on said semiconductor substrate (301) outside said side-wall conductor layer, said high-concentration impurity region being of the same conductivity type as that of said low-concentration impurity region.

89/87187 EP

FIG. 1

FIG. 2

(a)

306
309
302
305
301

(b)

309
306
308a
302
305
301

(c)

309
306a
306
308
302
305
304
301

FIG.3